# EUROPEAN PATENT SPECIFICATION

(11) **EP 3 643 499 B1**
(45) Date of publication and mention of the grant of the patent: **05.01.2022**
(21) Application number: 18821557.8
(22) Date of filing: 11.02.2018
(51) Int. Cl.: B32B 37/10, G02F 1/13, H01L 51/56

(54) **FILM COATING APPARATUS AND FILM COATING METHOD**
FOLIENAUFBRINGUNGSVORRICHTUNG UND FOLIENAUFBRINGUNGSVERFAHREN
DISPOSITIF D'APPLICATION DE FILM ET PROCÉDÉ D'APPLICATION DE FILM

(30) Priority: 19.06.2017 CN 201710464893
(43) Date of publication of application: 29.04.2020
(73) Proprietor: BOE Technology Group Co., Ltd., Beijing 100015 (CN); Hefei Xinsheng Optoelectronics Technology Co., Ltd., Xinzhan Industrial Park Hefei Anhui 230012 (CN)
(72) Inventor: DING, Xianlin, Beijing 100176 (CN); KUO, Tsung Chieh, Beijing 100176 (CN); CHEN, Qicheng, Beijing 100176 (CN)
(74) Representative: Potter Clarkson
(86) International application number: PCT/CN2018/076311
(87) International publication number: WO 2018/233304

(56) References cited:
- WO-A1-2016/035930
- CN-A- 105 398 181
- CN-A- 107 160 809
- CN-U- 202 862 765
- US-A1- 2011 120 619
- US-A1- 2014 179 191
- US-A1- 2015 258 759

## Description

### TECHNICAL FIELD

The present disclosure relates to the technical field of manufacturing a display device, and in particular, to a film coating apparatus and a film coating method.

### BACKGROUND

The flexible touch display device has the advantages of thin, light, wide viewing angle, active illumination, flexible display, and simple and direct operation, and has been considered as a promising next-generation display technology.

In the related art, a substrate thin film is usually coated on a glass substrate by using a film coating apparatus, and then a touch structure layer is formed on the substrate thin film by using the glass substrate as a support. After the formation, the substrate thin film is separated from the glass substrate to obtain a flexible touch thin film.

The film coating apparatus generally includes a substrate adsorption device and an coating device located under the substrate adsorption device, wherein: the substrate adsorption device has a bearing surface facing towards the coating device, and the bearing surface has a first adsorption structure; the coating device includes a screen plate disposed opposite to the bearing surface, a negative pressure tank located under the screen plate, and a press roll disposed inside the negative pressure tank. Before the film coating, the substrate adsorption device adsorbs the glass substrate to the bearing surface, the glass substrate has a photoresist on a side thereof facing towards the screen plate, and the coating device adsorbs the substrate thin film on the screen plate; during the film coating, the press roll extrudes the screen plate and moves parallel to the bearing surface, so as to ensure the substrate thin film to closely adhere to the glass substrate by the photoresist

However, the related art has a drawback in that the press roll applies a certain amount of pressing and pulling against a thin film when coating the thin film, so that the thin film generates a tensile stress. In the subsequent process, the thin film tends to shrink along the direction that the press roll moves, which causes the glass substrate to warp, so that the thin film coated on the glass substrate is prone to the phenomenon such as abnormal vacuum absorption and abnormal flow, which seriously affects the product quality of the touch thin film.

A film coating apparatus according to the background art is disclosed in CN 105 398 181 A.

### SUMMARY

The embodiments of the present disclosure provides a film coating apparatus as defined in claim 1 and a film coating method as defined in claim 9 to improve the adhesion of the thin film to the substrate, and thereby to improve the product quality of the flexible touch thin film.

An embodiment of the present disclosure provides a film coating apparatus for coating a thin film on a substrate, the film coating apparatus including a substrate fixing device, a thin film bearing device, and a press roll. The substrate fixing device has an arched surface for fixing the substrate; the thin film bearing device has a bearing surface opposite to the arched surface, the thin film bearing device is detachably disposed to the bearing surface; the press roll is located at a side of the thin film away from the substrate fixing device, and may move towards the substrate and roll from one end of the thin film to the other end.

In the film coating apparatus provided by the embodiment of the present disclosure, before coating the thin film, the substrate fixing device fixes the substrate on the arched surface, and the substrate is slightly arched downwards; during the process of coating the thin film, the press roll presses the thin film towards the arched surface, and rolls at a side of the thin film away from the arched surface, so that a portion of the thin film opposite to the press roll is closely adhered to the substrate, and at which time the thin film generates a tensile stress; after the thin film is coated, the substrate returns to an original state, and the thin film generates a compressive stress which is offset by the tensile stress. Compared with the related art, the film coating apparatus improves the shrinkage of the thin film and the adhesion of the thin film to the substrate, thereby improving the product quality of the touch thin film.

In one embodiment, a convexity d of the arched surface ridge and a thickness a of the substrate satisfy: d≤2a. The convexity of the arched surface takes a value within this range, so that a warpage of the substrate can be reduced, thereby improving the adhesion of the thin film to the substrate.

The thin film bearing device further includes a screen plate disposed between the bearing surface and the thin film and opposite to the arched surface, the press roll being located at a side of the screen plate away from the thin film. The thin film bearing device fixes the thin film on the screen plate, which can reduce the wrinkling of the thin film, thereby improving the adhesion of the thin film to the substrate.

In one embodiment, the thin film bearing device further includes a first adsorption structure for adsorbing the thin film.

In one embodiment, the thin film bearing device further includes a screen plate having a plurality of meshes disposed between the bearing surface and the thin film, the first adsorption structure including a first suction pipe correspondingly disposed to a side of each mesh away from the thin film, and the first suction pipe being in communication with a corresponding mesh.

In one embodiment, the first adsorption structure includes a plurality of first adsorption pads disposed on the bearing surface, and corresponding to each of first adsorption pads, a first suction pipe disposed to a side of the first adsorption pad away from the thin film, the first suction pipe being in communication with the corresponding first adsorption pad.

In one embodiment, the substrate fixing device further includes a second adsorption structure for adsorbing the substrate, the second adsorption structure including a plurality of second adsorption pads disposed on the arched surface, and a second suction pipe disposed at a side of the second adsorption pad away from the thin film, the second suction pipe being in communication with the corresponding second adsorption pad. The second adsorption structure relatively closely adsorbs and fixes the substrate on the arched surface, thereby reducing the wrinkling of the substrate, and improving the adhesion of the thin film to the substrate.

In one embodiment, the thin film bearing device further includes a first driving device connected to the press roll for driving the press roll to press the thin film against the arched surface and roll at a side of the thin film away from the arched surface.

In one embodiment, the substrate fixing device further includes a rotating shaft disposed at a side of the arched surface away from the thin film bearing device, the rotating shaft having a first rotational position for making the arched surface facing towards the thin film bearing device, and a second rotational position for making the arched surface facing away from the thin film bearing device. The rotating shaft rotates the substrate fixing device to the first rotational position during fixing of the substrate; and the rotating shaft rotates the substrate fixing device to the second rotational position after the substrate is fixed, so as to facilitate fixing of the substrate on the arched surface.

An embodiment of the present disclosure further provides a film coating method applied to the film coating apparatus according to the foregoing technical solutions, including:
fixing the substrate on an arched surface of a substrate fixing device;
placing a thin film on a bearing surface of a thin film bearing device;
controlling a press roll to press the thin film towards the arched surface and roll from one end of the thin film to the other end, so that a portion of the thin film opposite to the press roll is coated to the substrate.

In one embodiment, a convexity d of the arched surface and a thickness a of the substrate satisfy: d≤2a.

The method further includes: providing a screen plate between the bearing surface and the thin film and opposite to the arched surface, and providing the press roll at a side of the screen plate away from the thin film, controlling the press roll to press the screen plate and the thin film against the arched surface and roll from one end of the screen plate to the other end, so that a portion of the thin film opposite to the press roll is coated on the substrate.

In an embodiment, the method further includes: providing a first adsorption structure for adsorbing the thin film on the thin film bearing device.

In an embodiment, the method further includes: providing a screen plate between the bearing surface of the thin film bearing device and the thin film, wherein the first absorbing structure includes a first suction pipe correspondingly disposed to a side of each mesh away from the thin film, and the first suction pipe is in communication with a corresponding mesh.

In one embodiment, the first adsorption structure includes a plurality of first adsorption pads disposed on the bearing surface, and corresponding to each of first adsorption pads, a first suction pipe disposed to a side of the first adsorption pad away from the thin film, the first suction pipe being in communication with the corresponding first adsorption pad.

In an embodiment, the method further includes: providing a second adsorption structure for adsorbing the substrate on the substrate fixing device, the second adsorption structure including a plurality of second adsorption pads disposed on the arched surface, and a second suction pipe disposed at a side of the second adsorption pad away from the thin film, the second suction pipe being in communication with the corresponding second adsorption pad.

In one embodiment, the method further includes: providing, on the thin film bearing device, a first driving device connected to the press roll for driving the press roll to press the thin film against the arched surface and roll at a side of the thin film away from the arched surface.

In one embodiment, the method further includes: providing a rotating shaft at a side of the arched surface away from the thin film bearing device, the rotating shaft having a first rotational position for rotating the arched surface towards the thin film bearing device, and a second position for rotating the arched surface away from the thin film bearing device.

In the film coating method provided by the embodiment of the present disclosure, before coating the thin film, the substrate fixing device fixes the substrate on the arched surface, and the substrate is slightly arched downwards; during the process of coating the thin film, the press roll presses the thin film towards the arched surface, and rolls at a side of the thin film away from the arched surface, so that a portion of the thin film opposite to the press roll is closely adhered to the substrate, and at which time the thin film generates a tensile stress; after coating the thin film, the substrate returns to an original state, and the thin film produces a pressure stress which is offset by the tensile stress. Compared with the related art, the film coating method improves the shrinkage of the thin film and the adhesion of the thin film to the substrate, thereby improving the product quality of the touch thin film.

### BRIEF DESCRIPTION OF THE DRAWINGS

FIG. 1 is a schematic view of a film coating apparatus according to an embodiment of the present disclosure, not within the scope of the invention as claimed;
FIG. 2 is a schematic view of a film coating apparatus coating a thin film according to an embodiment of the present disclosure, not within the scope of the invention as claimed;
FIG. 3 is a schematic view of a thin film and a substrate during the film coating according to an embodiment of the present disclosure;
FIG. 4 is another schematic view of a film coating apparatus according to the present invention;
FIG. 5 is a schematic view of a film coating apparatus according to another embodiment of the present disclosure, not within the scope of the invention as claimed;
FIG. 6 is a schematic flow chart of a film coating method according to an embodiment of the present disclosure.

In the drawings:

1: substrate fixing device; 2: thin film bearing device; 3: substrate; 4: thin film; 11: arched surface; 12: rotating shaft; 13: second adsorption structure; 14: second adsorption pad; 15: second suction pipe; 20: bearing surface; 21: screen plate; 22: press roll; 23: first adsorption structure; 24: first adsorption pad; 25: first suction pipe; 26: mesh.

### DETAILED DESCRIPTION

Example embodiments will now be described more fully with reference to the accompanying drawings. However, the example embodiments can be embodied in a variety of forms, and should not be construed as being limited to the embodiments set forth herein; rather, these embodiments are provided so that this disclosure will be thorough and complete, and the concepts of the example embodiments will be fully given to those skilled in the art. The same reference numerals in the drawings denote the same or similar structures, and thus their detailed descriptions will be omitted.

Although the relative terms such as "on", "below", "upper" and "lower" are used in the specification to describe the relative relationship of one component to another component, these terms are used in this specification for convenience only, for example, a direction in the example according to the accompanying drawings. It should be understood that if the device is turned upside down, the "upper" component described above will become a "lower" component. When a structure is "on" another structure, it is possible that the structure is integrally formed on another structure, or that the structure is "directly" disposed on another structure, or that the structure is "indirectly" disposed on the other structure through other structures.

The terms "a", "an", "the", "said" are used to indicate the presence of one or more elements/components. The terms "comprise", "include", "have", "contain" and their variants are used to be open-type and are meant to include additional elements/components, etc., in addition to the listed elements/components/etc.; the terms "first", "second", etc. are only used as marks, rather than limitation of the number of objects.

In order to improve the adhesion of the thin film and the substrate, and further improve the product quality of the flexible touch thin film, embodiments of the present disclosure provide a film coating apparatus and a film coating method.

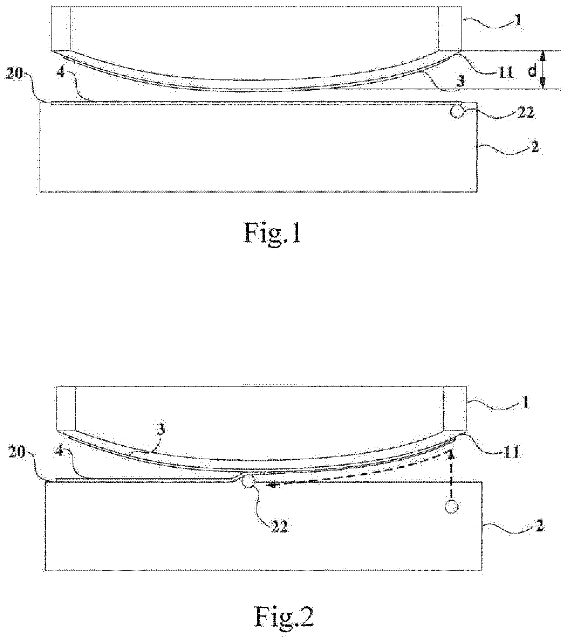

As shown in FIG. 1, an embodiment of the present disclosure, not within the scope of the invention as claimed, provides a film coating apparatus including a substrate fixing device 1, a thin film bearing device 2 and a press roll 22, wherein:
the substrate fixing device 1 has an arched surface 11 for fixing a substrate 3;
the thin film bearing device 2 has a bearing surface 20 opposite to the arched surface 11 for bearing a thin film 4;
the press roll 22 is located at a side of the thin film 4 away from the substrate fixing device 1, and when the press roll 22 presses the thin film 4 against the arched surface 11 and rolls at a side of the thin film 4 away from the arched surface 11, a portion of the thin film 4 opposite to the press roll 22 is coated to the substrate 3.

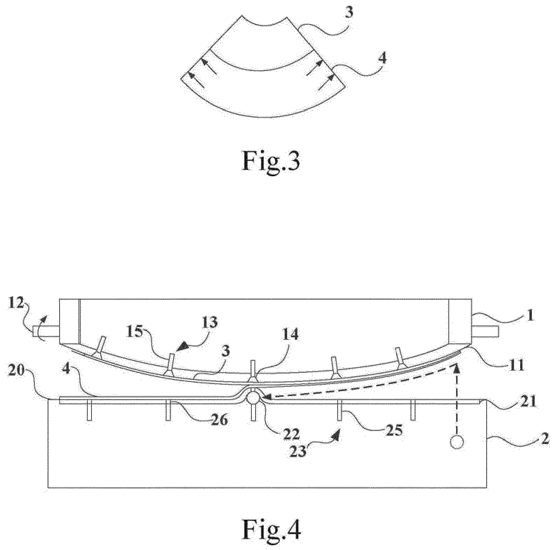

In the film coating apparatus provided by the embodiment of the present disclosure, before coating the thin film 4, the substrate fixing device 1 fixes the substrate 3 on the arched surface 11, and the substrate 3 is slightly drooped under the action of gravity. As seen from the broken line in Fig. 2, during the process of coating the thin film 4, the press roll 22 presses the thin film 4 against the arched surface 11 and rolls at a side of the thin film 4 away from the arched surface 11, so that a portion of the thin film 4 opposite to the press roll 22 is closely adhered to the substrate 3, and at which time the thin film 4 generates tensile stress, as shown in FIG. 3. After the thin film 4 is coated, the substrate 3 returns to an original state, at which time the thin film 4 generates a compressive stress which is offset by the tensile stress. Compared with the related art, the film coating apparatus improves the shrinkage of the thin film 4 and the adhesion of the thin film 4 to the substrate 3, thereby improving the product quality of the touch thin film.

In the embodiment of the present disclosure, a convexity d of the arched surface 11 and a thickness a of the base substrate 3 satisfy: d≤2a. The convexity of the arched surface 11 takes a value within this range, and the warpage of the substrate 3 can be reduced, thereby improving the adhesion of the thin film 4 to the substrate 3.

As shown in FIG. 4, according to the present invention, the thin film bearing device 2 further includes a screen plate 21 disposed between the bearing surface 20 and the thin film 4, the press roll 22 is located at a side of the screen plate 21 away from the thin film 4. When the press roll 22 presses the thin film 4 against the arched surface 11 via the screen plate 21 and rolls on the surface of the screen plate 21, a portion of the thin film 4 opposite to the press roll 22 is coated to the substrate 3. The thin film bearing device 2 fixes the thin film 4 on the screen plate 21, which can reduce the wrinkling of the thin film 4, thereby improving the adhesion of the thin film 4 to the substrate 3.

Referring to FIG. 4, in the present embodiment, the thin film bearing device 2 further includes a first adsorption structure 23 located at a side of the screen plate 21 away from the thin film 4, and the first adsorption structure 23 is used to absorb and fix the thin film 4 on the screen plate 21 via the screen plate 21; corresponding to each mesh 26 of the screen plate 21, the first adsorption structure 23 includes a first suction pipe 25 disposed at a side of the mesh 26 away from the thin film 4, and the first suction pipe 25 is in communication with the corresponding mesh 26. The first adsorption structure 23 adsorbs the thin film 4 on the screen plate 21, which can further reduce the wrinkling of the thin film 4, and improve the adhesion of the thin film 4 to the substrate 3.

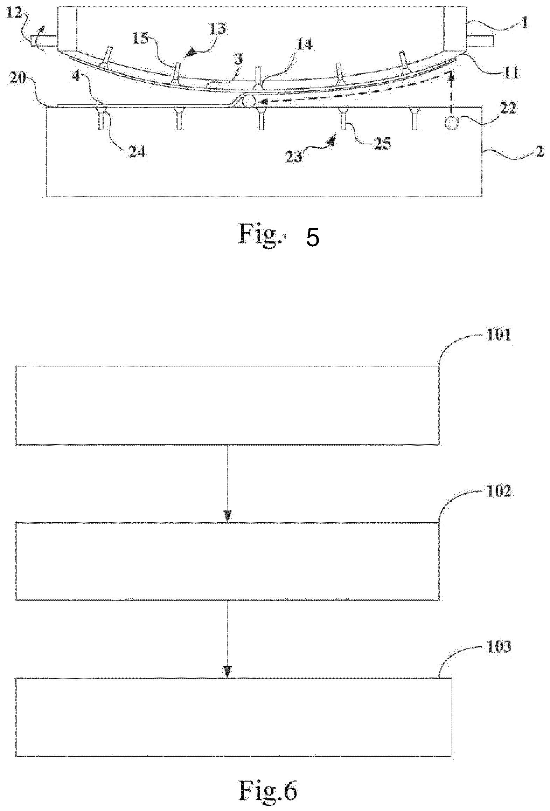

As shown in FIG. 5, in another embodiment of the present disclosure, the thin film bearing device 2 further includes a first adsorption structure 23 for adsorbing the thin film 4, and the first adsorption structure 23 includes a plurality of first adsorption pads 24 disposed on the bearing surface 20, and corresponding to each of first adsorption pads 24, a first suction pipe 25 disposed at a side of the first adsorption pad 24 away from the thin film 4, and the first suction pipe 25 is in communication with the corresponding first adsorption pad 24.

As shown in FIGS. 4 and 5, in one embodiment, the substrate fixing device 2 further includes a second adsorption structure 13 for adsorbing the substrate 3, and the second adsorption structure 13 includes a plurality of second adsorption pads 14 disposed on the arched surface 11, and corresponding to each of second adsorption pads 14, a second suction pipe 15 disposed at a side of the second adsorption pad 14 away from the thin film bearing device 2, and the second suction pipe 15 is in communication with the corresponding second adsorption pad 14. The second adsorption structure 13 relatively closely adsorbs and fixes the substrate 3 on the arched surface 11, thereby reducing the wrinkling of the substrate 3, and improving the adhesion of the thin film 4 to the substrate 3.

In the present embodiment, the thin film bearing device 2 further includes a first driving device connected to the press roll 22 for driving the press roll 22 to press the thin film 4 against the arched surface 11 and to roll at a side of the thin film 4 away from the arched surface 11.

As shown in FIG. 4 and FIG. 5, in the embodiment of the present disclosure, the substrate fixing device 1 further includes a rotating shaft 12 disposed at a side of the arched surface 11 away from the thin film bearing device 2. The rotating shaft 12 has a first rotational position for making the arched surface 11 facing towards the thin film bearing device 2, and a second rotational position for making the arched surface 11 facing away from the thin film bearing device 2. The rotating shaft 12 rotates the substrate fixing device 1 to the first rotational position during fixing of the substrate 3; and the rotating shaft 12 rotates the substrate fixing device 1 to the second rotational position after the substrate 3 is fixed, so as to facilitate fixing of the substrate on the arched surface.

In this embodiment, the film coating apparatus further includes a control device connected to the first driving device for controlling the first driving device to drive the press roll 22 to press the thin film 4 against the arched surface 11 and roll at a side of the thin film 4 away from the arched surface 11 after the thin filming apparatus is activated, so that a portion of the first adsorption structure 23 opposite to the press roll 22 is separated from the thin film 4, and so that a portion of the thin film 4 opposite to the press roll 22 is closely adhered to the substrate 3. With the design of this structure, the control device drives the press roll 22 by controlling the first driving device to automatically coat the thin film 4.

In an embodiment, the film coating apparatus further includes a second driving device for driving the rotating shaft 12, and the second driving device is connected to the control device. The control device controls the second driving device to drive the rotating shaft 12 so that the substrate fixing device 1 rotates to the first rotational position to face towards the thin film bearing device 2 during fixing of the substrate 3; the control device controls the second driving device to drive the rotating shaft 12 so that the substrate fixing device 1 rotates to the second rotational position facing away from the thin film bearing device 2 after the substrate 3 is fixed.

The control device is further connected to a first vacuuming device and a second vacuuming device, respectively, for controlling the first vacuuming device to vacuum the first adsorption structure 23 and controlling the second vacuuming device to vacuum the second adsorption structure 13 after the film coating device is activated.

As shown in FIG. 6, an embodiment of the present disclosure further provides a film coating method applied to the film coating apparatus of the foregoing embodiment, including:
step 101: fixing a substrate on an arched surface of a substrate fixing device;
step 102: placing a film on a bearing surface of a thin film bearing device;
step 103: controlling a press roll to press the thin film towards the arched surface and roll at a side of the thin film away from the arched surface, so that a portion of the thin film opposite to the press roll is coated to the substrate.

In the film coating method provided by the embodiment of the present disclosure, before coating the thin film 4, the substrate fixing device 1 absorbs and fixes the substrate 3 on the arched surface 11, and the substrate 3 is slightly arched downwards; during the process of coating the thin film 4, the press roll 22 presses the thin film 4 towards the arched surface 11, and rolls at a side of the thin film 4 away from the arched surface 11, so that a portion of the thin film 4 opposite to the press roll 22 is closely adhered to the substrate 3, and at which time the thin film 4 generates a tensile stress; after coating the thin film 4, the substrate 3 returns to an original state, and the thin film 4 produces a pressure stress which is offset by the tensile stress. Compared with the related art, the film coating method improves the shrinkage of the thin film 4 and the adhesion of the thin film 4 to the substrate 3, thereby improving the product quality of the touch thin film.

## Claims

1. A film coating apparatus for coating a thin film (4) on a substrate (3), wherein the film coating apparatus comprises:
a substrate fixing device (1) having an arched surface (11) for fixing the substrate (3);
a thin film bearing device (2) having a bearing surface (20) opposite to the arched surface (11), and the thin film (4) detachably disposed to the bearing surface (20);
a press roll (22) located at a side of the thin film (4) away from the substrate fixing device (1), and may move towards the substrate (3) and roll from one end of the thin film (4) to the other end;
**characterised in that**
the thin film bearing device (2) further comprises a screen plate (21) disposed between the bearing surface (20) and the thin film (4) and opposite to the arched surface (11), the press roll (22) being located at a side of the screen plate (21) away from the thin film (4).

2. The film coating apparatus according to claim 1, **characterized in that** a convexity d of the arched surface (11) ridge and a thickness a of the substrate (3) satisfy: d ≤ 2a.

3. The film coating apparatus according to claim 1, **characterized in that** the thin film bearing device (2) further comprises a first adsorption structure (23) for adsorbing the thin film (4).

4. The film coating apparatus according to claim 3, **characterized in that** the thin film bearing device (2) further comprises a screen plate (21) having a plurality of meshes disposed between the bearing surface (20) and the thin film (4),
the first adsorption structure (23) comprising a first suction pipe (25) correspondingly disposed to a side of each mesh (26) away from the thin film (4), and the first suction pipe (25) being in communication with a corresponding mesh (26).

5. The film coating apparatus according to claim 3, **characterized in that** the first adsorption structure (23) comprises a plurality of first adsorption pads (24) disposed on the bearing surface (20), and first suction pipes (25) disposed to a side of the first adsorption pad (24) away from the thin film (4), the first suction pipes (25) being in communication with the corresponding first adsorption pads (24).

6. The film coating apparatus according to claim 3, **characterized in that** the substrate fixing device (1) further comprises a second adsorption structure (13) for adsorbing the substrate (3), the second adsorption structure (13) comprises a plurality of second adsorption pads (14) disposed on the arched surface (11), and second suction pipes (15) disposed at a side of the second adsorption pads (14) away from the thin film (4), the second suction pipes (15) being in communication with the corresponding second adsorption pads (14).

7. The film coating apparatus according to claim 1, **characterized in that** the thin film bearing device (2) further comprises a first driving device connected to the press roll (22) for driving the press roll (22) to press the thin film (4) against the arched surface (11) and roll at a side of the thin film (4) away from the arched surface (11).

8. The film coating apparatus according to claim 1, **characterized in that** said substrate fixing device (1) further comprises a rotating shaft (12) disposed at a side of the arched surface (11) away from the thin film (4) bearing device (2), the rotating shaft (12) having a first rotational position for making the arched surface (11) facing towards the thin film (4) bearing device (2), and a second rotational position for making the arched surface (11) facing away from the thin film (4) bearing device (2).

9. A film coating method applied to the thin film (4) coating apparatus according to claim 1, comprising:
fixing a substrate (3) on an arched surface (11) of a substrate fixing device (1);
placing a thin film (4) on a bearing surface (20) of a thin film (4) bearing device (2);
controlling a press roll (22) to press the thin film (4) towards the arched surface (11) and roll from one end of the thin film (4) to the other end, so that a portion of the thin film (4) opposite to the press roll (22) is coated to the substrate (3);
**characterised in**
providing a screen plate (21) between the bearing surface (20) and the thin film (4) and opposite to the arched surface (11), and providing the press roll (22) at a side of the screen plate (21) away from the thin film (4), controlling the press roll (22) to press the screen plate (21) and the thin film (4) against the arched surface (11) and roll from one end of the screen plate (21) to the other end, so that a portion of the thin film (4) opposite to the press roll (22) is coated on the substrate (3).

10. The film coating method according to claim 9, **characterized in that** a convexity d of the arched surface (11) and a thickness a of the substrate (3) satisfy: d≤2a.

11. The film coating method according to claim 9, **characterized in that** further comprising:
providing a first adsorption structure (23) for adsorbing the thin film (4) on the thin film (4) bearing device (2);
providing a screen plate (21) having a plurality of meshes between the bearing surface (20) of the thin film bearing device (2) and the thin film (4), wherein the first absorbing structure includes a first suction pipe (25) correspondingly disposed to a side of each mesh (26) away from the thin film (4), and the first suction pipe (25) is in communication with a corresponding mesh (26).

12. The film coating method according to claim 9, **characterized in that**:
providing a first adsorption structure (23) for adsorbing The film on The film bearing device (2);
the first adsorption structure (23) comprises a plurality of first adsorption pads (24) disposed on the bearing surface (20), and corresponding to each of first adsorption pads (24), a first suction pipe (25) disposed to a side of the first adsorption pad (24) away from the thin film (4), the first suction pipe (25) being in communication with the corresponding first adsorption pad (24).

13. The film coating method according to claim 11, **characterized in that** further comprising:
providing a second adsorption structure (13) for adsorbing the substrate (3) on the substrate fixing device (1), the second adsorption structure (13) including a plurality of second adsorption pads (14) disposed on the arched surface (11), and a second suction pipe (15) disposed at a side of the second adsorption pad (14) away from the thin film (4), the second suction pipe (15) being in communication with the corresponding second adsorption pad (14).

## Patentansprüche

1. Filmbeschichtungseinrichtung zum Beschichten eines Dünnfilms (4) auf einem Substrat (3), wobei die Filmbeschichtungseinrichtung Folgendes umfasst:
eine Substratfixiervorrichtung (1), die eine gewölbte Oberfläche (11) zum Fixieren des Substrats (3) aufweist;
eine Dünnfilmlagervorrichtung (2), die eine Lageroberfläche (20) gegenüber der gewölbten Oberfläche (11) aufweist und den Dünnfilm (4), der an der Lageroberfläche (20) lösbar angeordnet ist;
eine Druckwalze (22), die sich an einer Seite des Dünnfilms (4) weg von der Substratfixiervorrichtung (1) befindet und sich in Richtung des Substrats (3) bewegen und von einem Ende des Dünnfilms (4) zu dem anderen Ende walzen kann;
**dadurch gekennzeichnet, dass** die Dünnfilmlagervorrichtung (2) ferner eine Siebplatte (21), die zwischen der Lageroberfläche (20) und dem Dünnfilm (4) und gegenüber der gewölbten Oberfläche (11) angeordnet ist, umfasst, wobei sich die Druckwalze (22) an einer Seite der Siebplatte (21) weg von dem Dünnfilm (4) befindet.

2. Filmbeschichtungseinrichtung nach Anspruch 1, **dadurch gekennzeichnet, dass** eine Konvexität d des gewölbten Oberflächen(11)grats und eine Dicke a des Substrats (3) Folgendes erfüllen: d ≤ 2a.

3. Filmbeschichtungseinrichtung nach Anspruch 1, **dadurch gekennzeichnet, dass** die Dünnfilmlagervorrichtung (2) ferner eine erste Adsorptionsstruktur (23) zum Adsorbieren des Dünnfilms (4) umfasst.

4. Filmbeschichtungseinrichtung nach Anspruch 3, **dadurch gekennzeichnet, dass** die Dünnfilmlagervorrichtung (2) ferner eine Siebplatte (21), die mehrere Maschen aufweist, die zwischen der Lageroberfläche (20) und dem Dünnfilm (4) angeordnet sind, umfasst,
wobei die erste Adsorptionsstruktur (23) ein erstes Saugrohr (25), das entsprechend an einer Seite jeder Masche (26) weg von dem Dünnfilm (4) angeordnet ist, umfasst, und das erste Saugrohr (25) mit einer entsprechenden Masche (26) in Verbindung steht.

5. Filmbeschichtungseinrichtung nach Anspruch 3, **dadurch gekennzeichnet, dass** die erste Adsorptionsstruktur (23) mehrere erste Adsorptionskissen (24), die auf der Lageroberfläche (20) angeordnet sind, und erste Saugrohre (25), die an einer Seite des ersten Adsorptionskissens (24) weg von dem Dünnfilm (4) angeordnet sind, umfasst, wobei die ersten Saugrohre (25) mit den entsprechenden ersten Adsorptionskissen (24) in Verbindung stehen.

6. Filmbeschichtungseinrichtung nach Anspruch 3, **dadurch gekennzeichnet, dass** die Substratfixiervorrichtung (1) ferner eine zweite Adsorptionsstruktur (13) zum Adsorbieren des Substrats (3) umfasst, wobei die zweite Adsorptionsstruktur (13) mehrere zweite Adsorptionskissen (14), die auf der gewölbten Oberfläche (11) angeordnet sind, und zweite Saugrohre (15), die an einer Seite der zweiten Adsorptionskissen (14) weg von dem Dünnfilm (4) angeordnet sind, umfasst, wobei die zweiten Saugrohre (15) mit den entsprechenden zweiten Adsorptionskissen (14) in Verbindung stehen.

7. Filmbeschichtungseinrichtung nach Anspruch 1, **dadurch gekennzeichnet, dass** die Dünnfilmlagervorrichtung (2) ferner eine erste Antriebsvorrichtung, die mit der Druckwalze (22) zum Antreiben der Druckwalze (22) verbunden ist, um den Dünnfilm (4) gegen die gewölbte Oberfläche (11) zu drücken, und an einer Seite des Dünnfilms (4) weg von der gewölbten Oberfläche (11) zu walzen, umfasst.

8. Filmbeschichtungseinrichtung nach Anspruch 1, **dadurch gekennzeichnet, dass** die Substratfixiervorrichtung (1) ferner eine Drehwelle (12), die an einer Seite der gewölbten Oberfläche (11) weg von der Lagervorrichtung (2) des Dünnfilms (4) angeordnet ist, umfasst, wobei die Drehwelle (12) eine erste Drehposition zum Veranlassen der gewölbten Oberfläche (11), in Richtung der Lagervorrichtung (2) des Dünnfilms (4) zu zeigen, und eine zweite Drehposition zum Veranlassen der gewölbten Oberfläche (11), weg von der Lagervorrichtung (2) des Dünnfilms (4) zu zeigen, aufweist.

9. Filmbeschichtungsverfahren, das auf die Beschichtungseinrichtung des Dünnfilms (4) nach Anspruch 1 angewandt wird, das Folgendes umfasst:
Fixieren eines Substrats (3) auf einer gewölbten Oberfläche (11) einer Substratfixiervorrichtung (1);
Platzieren eines Dünnfilms (4) auf einer Lageroberfläche (20) einer Lagervorrichtung (2) eines Dünnfilms (4);
Steuern einer Druckwalze (22), um den Dünnfilm (4) in Richtung der gewölbten Oberfläche (11) zu drücken und von einem Ende des Dünnfilms (4) zu dem anderen Ende zu walzen, so dass ein Abschnitt des Dünnfilms (4) gegenüber der Druckwalze (22) auf das Substrat (3) beschichtet wird;
**gekennzeichnet durch** Bereitstellen einer Siebplatte (21) zwischen der Lageroberfläche (20) und dem Dünnfilm (4) und gegenüber der gewölbten Oberfläche (11) und Bereitstellen der Druckwalze (22) an einer Seite der Siebplatte (21) weg von dem Dünnfilm (4), Steuern der Druckwalze (22), um die Siebplatte (21) und den Dünnfilm (4) gegen die gewölbte Oberfläche (11) zu drücken und von einem Ende der Siebplatte (21) zu dem anderen Ende zu walzen, so dass ein Abschnitt des Dünnfilms (4) gegenüber der Druckwalze (22) auf das Substrat (3) beschichtet wird.

10. Filmbeschichtungsverfahren nach Anspruch 9, **dadurch gekennzeichnet, dass** eine Konvexität d der gewölbten Oberfläche (11) und eine Dicke a des Substrats (3) Folgendes erfüllen: d≤2a.

11. Filmbeschichtungsverfahren nach Anspruch 9, **dadurch gekennzeichnet, dass** es ferner Folgendes umfasst:
Bereitstellen einer ersten Adsorptionsstruktur (23) zum Adsorbieren des Dünnfilms (4) auf der Lagervorrichtung (2) des Dünnfilms (4);
Bereitstellen einer Siebplatte (21), die mehrere Maschen zwischen der Lageroberfläche (20) der Lagervorrichtung (2) des Dünnfilms und dem Dünnfilm (4) aufweist, wobei die erste Adsorptionsstruktur ein erstes Saugrohr (25), das entsprechend an einer Seite jeder Masche (26) weg von dem Dünnfilm (4) angeordnet ist, beinhaltet, und das erste Saugrohr (25) mit einer entsprechenden Masche (26) in Verbindung steht.

12. Filmbeschichtungsverfahren nach Anspruch 9, **gekennzeichnet durch** Folgendes:
Bereitstellen einer ersten Adsorptionsstruktur (23) zum Adsorbieren des Films auf der Filmlagervorrichtung (2);
die erste Adsorptionsstruktur (23), die mehrere erste Adsorptionskissen (24), die auf der Lageroberfläche (20) angeordnet sind, und jedem der ersten Adsorptionskissen (24) entsprechend, ein erstes Saugrohr (25), das an einer Seite des ersten Adsorptionskissens (24) weg von dem Dünnfilm (4) angeordnet ist, umfasst, wobei das erste Saugrohr (25) mit dem entsprechenden ersten Adsorptionskissen (24) in Verbindung steht.

13. Filmbeschichtungsverfahren nach Anspruch 11, **dadurch gekennzeichnet, dass** es ferner Folgendes umfasst:
Bereitstellen einer zweiten Adsorptionsstruktur (13) zum Adsorbieren des Substrats (3) auf der Substratfixiervorrichtung (1), wobei die zweite Adsorptionsstruktur (13) mehrere zweite Adsorptionskissen (14) beinhaltet, die auf der gewölbten Oberfläche (11) angeordnet sind, und ein zweites Saugrohr (15), das an einer Seite des zweiten Adsorptionskissens (14) weg von dem Dünnfilm (4) angeordnet ist, wobei das zweite Saugrohr (15) mit dem entsprechenden zweiten Adsorptionskissen (14) in Verbindung steht.

## Revendications

1. Appareil de pelliculage permettant de revêtir un film mince (4) sur un substrat (3), dans lequel l'appareil de revêtement de film comprend :
un dispositif de fixation de substrat (1) ayant une surface arquée (11) pour fixer le substrat (3) ;
un dispositif de palier de film mince (2) ayant une surface de palier (20) opposée à la surface arquée (11), et le film mince (4) disposé de manière détachable sur la surface de palier (20) ;
un rouleau presseur (22) situé sur un côté du film mince (4) loin du dispositif de fixation de substrat (1), et peut se déplacer vers le substrat (3) et rouler d'une extrémité du film mince (4) vers l'autre extrémité ;
**caractérisé en ce que** le dispositif de palier de film mince (2) comprend en outre une plaque de tamis (21) disposée entre la surface de palier (20) et le film mince (4) et opposée à la surface arquée (11), le rouleau presseur (22) étant situé sur un côté de la plaque de tamis (21) loin du film mince (4).

2. Appareil de pelliculage selon la revendication 1, **caractérisé en ce qu'**une convexité d de l'arête de la surface arquée (11) et une épaisseur a du substrat (3) satisfont : d ≤ 2a.

3. Appareil de pelliculage selon la revendication 1, **caractérisé en ce que** le dispositif de palier de film mince (2) comprend en outre une première structure d'adsorption (23) pour adsorber le film mince (4).

4. Appareil de pelliculage selon la revendication 3, **caractérisé en ce que** le dispositif de palier de film mince (2) comprend en outre une plaque de tamis (21) ayant une pluralité de mailles disposées entre la surface de support (20) et le film mince (4),
la première structure d'adsorption (23) comprenant un premier tuyau d'aspiration (25) disposé de manière correspondante sur un côté de chaque maille (26) loin du film mince (4), et le premier tuyau d'aspiration (25) étant en communication avec une maille correspondante (26).

5. Appareil de pelliculage selon la revendication 3, **caractérisé en ce que** la première structure d'adsorption (23) comprend une pluralité de premiers segments d'adsorption (24) disposés sur la surface de palier (20), et des premiers tuyaux d'aspiration (25) disposés sur un côté du premier segment d'adsorption (24) loin du film mince (4), les premiers tuyaux d'aspiration (25) étant en communication avec les premiers segments d'adsorption correspondants (24).

6. Appareil de pelliculage selon la revendication 3, **caractérisé en ce que** le dispositif de fixation de substrat (1) comprend en outre une seconde structure d'adsorption (13) pour adsorber le substrat (3), la seconde structure d'adsorption (13) comprend une pluralité de seconds segments d'adsorption (14) disposés sur la surface arquée (11), et des seconds tuyaux d'aspiration (15) disposés sur un côté des seconds segments d'adsorption (14) loin du film mince (4), les seconds tuyaux d'aspiration (15) étant en communication avec les seconds segments d'adsorption correspondants (14).

7. Appareil de pelliculage selon la revendication 1, **caractérisé en ce que** le dispositif de palier de film mince (2) comprend en outre un premier dispositif d'entraînement relié au rouleau presseur (22) pour entraîner le rouleau presseur (22) pour presser le film mince (4) contre la surface arquée (11) et rouler sur un côté du film mince (4) loin de la surface arquée (11).

8. Appareil de pelliculage selon la revendication 1, **caractérisé en ce que** ledit dispositif de fixation de substrat (1) comprend en outre un arbre rotatif (12) disposé sur un côté de la surface arquée (11) loin du dispositif de palier de film mince (4) (2), l'arbre rotatif (12) ayant une première position de rotation pour rendre la surface arquée (11) tournée vers le dispositif de palier (2) de film mince (4), et une seconde position de rotation pour rendre la surface arquée (11) tournée vers l'extérieur du dispositif de palier (2) de film mince (4).

9. Procédé de pelliculage appliqué à l'appareil de revêtement de film mince (4) selon la revendication 1, comprenant :
la fixation d'un substrat (3) sur une surface arquée (11) d'un dispositif de fixation de substrat (1) ;
le placement d'un film mince (4) sur une surface de palier (20) d'un dispositif de palier (2) de film mince (4) ;
la commande d'un rouleau presseur (22) pour presser le film mince (4) vers la surface arquée (11) et rouler d'une extrémité du film mince (4) vers l'autre extrémité, de sorte qu'une partie du film mince (4) opposée au rouleau presseur (22) est revêtue sur le substrat (3) ;
**caractérisé par** la fourniture d'une plaque de tamis (21) entre la surface de palier (20) et le film mince (4) et opposée à la surface arquée (11), et la fourniture du rouleau presseur (22) sur un côté de la plaque de tamis (21) loin du film mince (4), la commande du rouleau presseur (22) pour presser la plaque de tamis (21) et le film mince (4) contre la surface arquée (11) et pour rouler d'une extrémité de la plaque de tamis (21) vers l'autre extrémité, de sorte qu'une partie du film mince (4) opposée au rouleau presseur (22) est revêtue sur le substrat (3).

10. Procédé de pelliculage selon la revendication 9, **caractérisé en ce qu'**une convexité d de la surface arquée (11) et une épaisseur a du substrat (3) satisfont : d ≤ 2a.

11. Procédé de pelliculage selon la revendication 9, **caractérisé en ce qu'**il comprend en outre :
la fourniture d'une première structure d'adsorption (23) pour adsorber le film mince (4) sur le dispositif de palier de film mince (4) (2) ;
la fourniture d'une plaque de tamis (21) ayant une pluralité de mailles entre la surface de palier (20) du dispositif de palier de film mince (2) et le film mince (4), dans lequel la première structure d'absorption comprend un premier tuyau d'aspiration (25) de manière correspondante disposé sur un côté de chaque maille (26) loin du film mince (4), et le premier tuyau d'aspiration (25) est en communication avec une maille correspondante (26).

12. Procédé selon la revendication 9, **caractérisé en ce que** :
la fourniture d'une première structure d'adsorption (23) pour adsorber le film sur le dispositif de palier de film (2) ;
la première structure d'adsorption (23) comprend une pluralité de premiers segments d'adsorption (24) disposés sur la surface de palier (20), et correspondant à chacun des premiers segments d'adsorption (24), un premier tuyau d'aspiration (25) disposé d'un côté du premier segment d'adsorption (24) loin du film mince (4), le premier tuyau d'aspiration (25) étant en communication avec le premier segment d'adsorption correspondant (24).

13. Procédé de pelliculage selon la revendication 11, **caractérisé en ce qu'**il comprend en outre :
la fourniture d'une seconde structure d'adsorption (13) pour adsorber le substrat (3) sur le dispositif de fixation de substrat (1), la seconde structure d'adsorption (13) comprenant une pluralité de seconds segments d'adsorption (14) disposés sur la surface arquée (11), et un second tuyau d'aspiration (15) disposé sur un côté du second segment d'adsorption (14) loin du film mince (4), le second tuyau d'aspiration (15) étant en communication avec le second segment d'adsorption correspondant (14).
